# EUROPEAN PATENT APPLICATION

(11) **EP 4 478 423 A1**
(43) Date of publication of application: **18.12.2024**
(21) Application number: 23769425.2
(22) Date of filing: 08.01.2023
(51) Int. Cl.: H01L 29/78, H01L 21/336

(54) **VERTICAL CHANNEL TRANSISTOR STRUCTURE AND MANUFACTURING METHOD THEREFOR?**

(30) Priority: 14.03.2022 CN 202210247054
(71) Applicant: Huawei Technologies Co., Ltd., Shenzhen, Guangdong 518129 (CN)
(72) Inventor: HUANG, Kailiang, Shenzhen, Guangdong 518129 (CN); JING, Weiliang, Shenzhen, Guangdong 518129 (CN); WANG, Zhaogui, Shenzhen, Guangdong 518129 (CN); FENG, Junxiao, Shenzhen, Guangdong 518129 (CN); WANG, Zhengbo, Shenzhen, Guangdong 518129 (CN)
(74) Representative: Maiwald GmbH
(86) International application number: PCT/CN2023/071143
(87) International publication number: WO 2023/173914

(57) **Abstract**

Embodiments of this application disclose a vertical channel transistor structure. Contact layers are respectively introduced between a source and a dielectric layer, and between a drain and the dielectric layer. The two contact layers each have a low resistance and high doping concentration, and are in good contact with metal, so that ohmic contact may be formed between the source and a semiconductor channel layer and between the drain and the semiconductor channel layer. When a vertical channel transistor with this structure operates, electrons may, through a barrier due to fluctuation, directly enter the semiconductor channel layer from the source and enter the drain from the semiconductor channel layer, that is, tunneling injection of a current is implemented. This greatly reduces a contact resistance of the vertical channel transistor, and increases an operating current of the vertical channel transistor.

## Description

This application claims priority to Chinese Patent Application No. 202210247054.2, filed with the China National Intellectual Property Administration on March 14, 2022 and entitled "VERTICAL CHANNEL TRANSISTOR STRUCTURE AND MANUFACTURING METHOD", which is incorporated herein by reference in its entirety.

### TECHNICAL FIELD

This application relates to the field of semiconductor technologies, and in particular, to a vertical channel transistor and a manufacturing method.

### BACKGROUND

A transistor with a vertical channel becomes one of mainstream choices, to increase density of a storage array and reduce costs. The vertical channel transistor has a natural short-channel characteristic, and a semiconductor channel is located between a bottom electrode and a top electrode in a sandwich structure. Therefore, research and development of the vertical transistor are expected to be a new direction of device miniaturization. This can reduce a channel length to below 10 nm or even 5 nm.

However, for the transistor with the vertical channel, there is a great challenge to technically implement effective doping of the vertical channel. Effective control on consistency in a direction of a doping depth and control on consistency between doping concentration of a source and doping concentration of a drain are included. As a result, a contact resistance of a manufactured vertical channel transistor is usually very large. This greatly affects electrical performance of the transistor. If overall doping concentration of the transistor is increased to reduce the contact resistance, a negative shift of a threshold voltage is caused. The negative shift of the threshold voltage means that the transistor is turned on in advance. Under a given voltage of a system, electric leakage increases and an electric loss increases. In the conventional technology, a multi-layer partition doping manner may be used to resolve the foregoing problem, but process costs are increased, and a reliability risk is caused.

### SUMMARY

Embodiments of this application provide a vertical channel transistor structure and a manufacturing method, to effectively reduce a contact resistance of a vertical channel transistor.

A first aspect of this application provides a vertical channel transistor structure. The structure includes a stacked structure, where the stacked structure includes a first metal layer, a first contact layer, an insulation dielectric layer, a second contact layer, and a second metal layer, the first contact layer is located between the first metal layer and the insulation dielectric layer, and the second contact layer is located between the second metal layer and the insulation dielectric layer. The stacked structure is provided with a groove, the groove penetrates the second metal layer, the second contact layer, the insulation dielectric layer, and the second contact layer, and the first groove is at least partially recessed into the first metal layer. A semiconductor channel layer, a gate oxygen dielectric layer, and a gate are disposed in the groove. Materials of the first contact layer and the second contact layer are conductor materials or semiconductor materials whose conductivities are higher than that of the semiconductor channel layer. The semiconductor channel layer is separately in contact with the first metal layer and the second metal layer in the groove, and the gate oxygen dielectric layer is disposed between the semiconductor channel layer and the gate.

It should be understood that one of the first metal layer and the second metal layer is a source, and the other is a drain.

In the conventional technology, electrons need to pass through two contact surfaces from the source to the semiconductor channel layer and then to the drain: a contact surface between the source and the semiconductor channel layer and a contact surface between the semiconductor channel layer and the drain. Both contact between the source and the semiconductor channel layer and contact between the semiconductor channel layer and the drain are usually Schottky contact in the vertical device structure, and a thermal excitation mode is used for current injection. As a result, a contact resistance is large, electronic potential energy required for passing through a barrier is large, and a current is small. However, in the vertical channel transistor structure provided in this application, contact layers are respectively disposed between the drain and the insulation dielectric layer and between the source and the insulation dielectric layer. Electrons need to pass through four contact surfaces in total from the source to the drain: a contact surface between the source and the first contact layer, a contact surface between the first contact layer and the semiconductor channel layer, a contact surface between the semiconductor channel layer and the second contact layer, and a contact surface between the second contact layer and the drain. Because the materials of the two contact layers are the conductor materials or the semiconductor materials whose conductivities are higher than that of the semiconductor channel layer, and the conductor materials used by the contact layers are different from metal of the source metal layer and metal of the drain metal layer, and can separately form good contact with the semiconductor channel layer, a contact resistance of the contact surface between the contact layer and the semiconductor channel layer is far less than a contact resistance of a contact surface between the source and the semiconductor channel layer and a contact resistance of a contact surface between the drain and the semiconductor channel layer. In addition, because the contact layer is in good contact with the metal, a contact resistance formed between the source and the contact layer and a contact resistance between the drain and the contact layer are also extremely small. Therefore, a sum of a resistance of the contact surface between the source and the contact layer and a resistance of the contact surface between the contact layer and the semiconductor channel layer is less than a resistance of the contact surface between the source and the semiconductor channel layer in the conventional technology. Correspondingly, a sum of a resistance of the contact surface between the drain and the contact layer and a resistance of the contact surface between the contact layer and the semiconductor channel layer is less than a resistance of the contact surface between the drain and the semiconductor channel layer in the conventional technology. Ideally, the contact resistance formed between the source and the contact layer and the contact resistance formed between the drain and the contact layer can be ignored. Therefore, after the two contact layers are introduced, a total resistance of the four contact surfaces through which the electrons pass from the source to the drain is less than a total resistance of the two contact surfaces through which the electrons pass from the source to the drain in the conventional technology, so that ohmic contact (which may also be referred to as ohmic-like contact) can be formed between the source and the semiconductor channel layer and between the drain and the semiconductor channel layer. Compared with a vertical channel transistor in which the contact layer is not disposed, in the vertical channel transistor in this embodiment, a contact resistance of the vertical channel transistor is greatly reduced, and a current flowing from the source to the drain is increased, that is, an operating current of the vertical channel transistor is increased. In other words, even if the contact layer uses the same semiconductor material as the channel layer, the contact resistance of the device can be reduced because a contact area between the semiconductor and the source/drain is increased. In addition, in embodiments of this application, in a condition that a horizontal area of the transistor device is not increased, the contact area between a channel and the source/drain can be increased, to effectively reduce the contact resistance, and a threshold of a channel material is kept unchanged, to improve device performance. Further, this solution of this application is widely applicable, and may be used to optimize a contact resistance of a transistor made of any material.

It should be understood that, it is assumed that a resistance between the source and the semiconductor channel is Rs, and a resistance between the drain and the semiconductor channel is Rd, the contact resistance of the transistor (which may also be referred to as a source-drain contact resistance) may be understood as a sum of Rs and Rd. When the contact resistance of the transistor is less than a specific threshold, it is considered that ohmic contact is formed in the transistor. The transistor with the ohmic contact has a small contact resistance and a large operating current. It should be understood that the contact resistance and the sum of Rs and Rd may be only approximate, but not necessarily strictly equal.

In a possible implementation, the groove is the first groove, the semiconductor channel layer covers a bottom and a side wall of the first groove to form a second groove, the gate oxygen dielectric layer covers a bottom and a side wall of the second groove to form a third groove, and the gate is disposed in the third groove.

In a possible implementation, the semiconductor channel layer, the gate oxygen dielectric layer, and the gate are sequentially disposed on a bottom surface of the groove; and the semiconductor channel layer, the gate oxygen dielectric layer, and the gate are sequentially disposed from outside to inside on the side wall of the groove.

In a possible implementation, the resistance of the contact surface formed between the first contact layer and the semiconductor channel layer and the resistance of the contact surface formed between the second contact layer and the semiconductor channel layer are respectively less than a resistance of a contact surface formed between the first metal layer and the semiconductor channel layer and a resistance of a contact surface formed between the second metal layer and the semiconductor channel layer.

In a possible implementation, a sum of a resistance of a contact surface formed between the first contact layer and the first metal layer and a resistance of a contact surface formed between the first contact layer and the semiconductor channel layer is less than a resistance of a contact surface formed between the first metal layer and the semiconductor channel layer; and a sum of a resistance of a contact surface formed between the second contact layer and the second metal layer and a resistance of a contact surface formed between the second contact layer and the semiconductor channel layer is less than a resistance of a contact surface formed between the second metal layer and the semiconductor channel layer.

In a possible implementation, the resistance of the contact surface formed between the first contact layer and the first metal layer and the resistance of the contact surface formed between the second contact layer and the second metal layer are less than a first threshold. Ideally, the first threshold is close to 0. Therefore, the resistance of the contact surface formed between the contact layer and the metal layer may be ignored.

In a possible implementation, when the materials of the first contact layer and the second contact layer are the conductor materials, if the semiconductor channel layer is an N-type semiconductor, the materials of the first contact layer and the second contact layer are first conductor materials, where a work function of the first conductor material is less than or close to electron affinity of the semiconductor channel layer; or if the semiconductor channel layer is a P-type semiconductor, the materials of the first contact layer and the second contact layer are second conductor materials, where a work function of the second conductor material is greater than or close to a sum of electron affinity and a band gap of the semiconductor channel layer.

In a possible implementation, when the materials of the first contact layer and the second contact layer are the semiconductor materials, if the semiconductor channel layer is a first N-type semiconductor, the materials of the first contact layer and the second contact layer are first semiconductor materials, where a conduction band location of the first semiconductor material is close to a conduction band location of the first N-type semiconductor, and a conductivity of the first semiconductor material is greater than or equal to a conductivity of the first N-type semiconductor; or if the semiconductor channel layer is a first P-type semiconductor, the materials of the first contact layer and the second contact layer are second semiconductor materials, where a valence band location of the second conductor material is close to a valence band location of the first P-type semiconductor, and a conductivity of the second conductor material is greater than or equal to a conductivity of the first P-type semiconductor. It should be understood that the vertical channel transistor provided in embodiments of this application may be a vertical channel thin film transistor (Thin Film Transistor, TFT).

It should be understood that the first contact layer and the second contact layer each may also be referred to as a transition layer, an ohmic contact layer, or an ohmic contact intercalation layer.

For example, the conductor materials of the first contact layer and the second contact layer include titanium Ti, gold Au, tungsten W, molybdenum Mo, aluminum Al, or titanium nitride TiN.

For example, the semiconductor materials used by the first contact layer and the second contact layer include indium gallium zinc oxide InGaZnO, indium zinc oxide InZnO, indium tin oxide InSnO, indium oxide In2O3, gallium oxide Ga2O3, indium titanium oxide InTiO, or zinc oxide ZnO.

For example, the materials used by the first contact layer and the second contact layer further include heavily doped P-type silicon Si and N-type Si, or any combination of the P-type silicon Si and the N-type Si.

In a possible implementation, the first contact layer and the second contact layer are doped semiconductor layers, and a material of the doped semiconductor layer is obtained by doping a material of the semiconductor channel layer.

The contact layer may use a same semiconductor as the semiconductor channel, but the semiconductor at the contact layer needs to be doped or processed in another way, so that the contact layer has a lower resistance. When the first contact layer and the second contact layer are semiconductors, the first contact layer and the second contact layer may also be referred to as the doped semiconductor layers, and a resistance of the doped semiconductor layer is lower than a resistance of the semiconductor channel layer.

In a possible implementation, the first contact layer, the second contact layer, and the semiconductor channel layer are all P-type semiconductors or N-type semiconductors; the first contact layer and the second contact layer are N-type semiconductors, and the semiconductor channel layer is a P-type semiconductor; or the first contact layer and the second contact layer are P-type semiconductors, and the semiconductor channel layer is an N-type semiconductor.

It should be understood that, if a material of an ohmic contact layer and a material of the semiconductor channel layer have a same polarity, the ohmic contact may be formed between the source/drain and the semiconductor channel layer after the ohmic contact layer is introduced. If a material of an ohmic contact layer and a material of the semiconductor channel layer have inconsistent polarities, doping concentration of the ohmic contact layer needs to be increased, to form PN junction ohmic contact between the source/drain and the semiconductor channel layer. This expands selection of a device material, this solution can be widely used to optimize a contact resistance of a device made of any material, and this implements a heterogeneous-contact transistor device.

In a possible implementation, the structure is in a cylindrical shape. The stacked structure surrounds the semiconductor channel layer, and the semiconductor channel layer is completely located in the vertical groove inside the stacked structure. This implementation is a channel-all-around (Channel-All-Around, CAA) manner.

In a possible implementation, the structure is in a square columnar shape. The stacked structure includes a first stacked substructure and a second stacked substructure, the semiconductor channel layer includes a first semiconductor channel layer and a second semiconductor channel layer, and the gate oxygen dielectric layer includes a first gate oxygen dielectric layer and a second gate oxygen dielectric layer. The gate is disposed between the first stacked substructure and the second stacked substructure. The first semiconductor channel layer and the first gate oxygen dielectric layer are disposed between the first stacked substructure and the gate, and the first semiconductor channel layer is in contact with a side surface of the first stacked substructure. The second semiconductor channel layer and the second gate oxygen dielectric layer are disposed between the second stacked substructure and the gate, and the second semiconductor channel layer is in contact with a side surface of the second stacked substructure.

After a middle part of the stacked structure is etched, two side walls remain, and a semiconductor channel layer, a gate oxygen dielectric layer, and a gate are sequentially disposed on an inner side of each of the two side walls. The two semiconductor channel layers are disposed close to the two side walls of the transistor, thereby generating two perpendicular channels. The double-channel structure can further increase an operating current of the vertical channel transistor device, and further increase an operating speed of a memory in which the vertical channel transistor is located.

In a possible implementation, the vertical channel transistor structure further includes a first interface layer and a second interface layer, where the first interface layer is located between the first contact layer and the insulation dielectric layer, and the second interface layer is located between the second contact layer and the insulation dielectric layer.

In a possible implementation, materials of the first interface layer and the second interface layer are the same as the materials of the first contact layer and the second contact layer, but doping concentration of the materials of the first interface layer and the second interface layer is lower than doping concentration of the materials of the first contact layer and the second contact layer.

The interface layer can effectively prevent a heavily doped element from diffusing into the insulation dielectric layer, thereby expanding a doping concentration window of the contact layer. The contact layer can be doped at higher concentration, so that a resistance of formed PN junction ohmic contact is smaller. In addition, when the first contact layer and the second contact layer are heavily doped (or the doping concentration is increased), the heavily doped element can be prevented from diffusing into the insulation isolation layer, and isolation effect of the insulation isolation layer is not affected.

A second aspect of this application provides a vertical channel transistor, including a stacked structure, where the stacked structure includes a first metal layer, a first contact layer, an insulation dielectric layer, a second contact layer, and a second metal layer, the first contact layer is located between the first metal layer and the insulation dielectric layer, and the second contact layer is located between the second metal layer and the insulation dielectric layer. The stacked structure is provided with a groove, the groove penetrates the second metal layer, the second contact layer, the insulation dielectric layer, and the second contact layer, and the first groove is at least partially recessed into the first metal layer. A semiconductor channel layer, a gate oxygen dielectric layer, and a gate are disposed in the groove. The semiconductor channel layer is separately in contact with the first metal layer and the second metal layer in the groove, and the gate oxygen dielectric layer is disposed between the semiconductor channel layer and the gate. A resistance of a contact surface formed between the first contact layer and the semiconductor channel layer and a resistance of a contact surface formed between the second contact layer and the semiconductor channel layer are respectively less than a resistance of a contact surface formed between the first metal layer and the semiconductor channel layer and a resistance of a contact surface formed between the second metal layer and the semiconductor channel layer.

In a possible implementation, the resistance of the contact surface formed between the first contact layer and the first metal layer and the resistance of the contact surface formed between the second contact layer and the second metal layer are less than a first threshold. For example, the first threshold is a small value, and is close to 0. In a possible implementation, materials of the first contact layer and the second contact layer are conductor materials, and the conductor materials of the first contact layer and the second contact layer are different from materials of the first metal layer and the second metal layer; or materials of the first contact layer and the second contact layer are semiconductor materials whose conductivities are higher than that of the semiconductor channel layer.

A third aspect of this application provides a vertical channel transistor, including a stacked structure and a semiconductor channel layer, where the stacked structure is provided with a vertical groove, and the semiconductor channel layer is disposed in the groove. The stacked structure includes a first metal layer, a second metal layer, and a third metal layer, the third metal layer is located between the first metal layer and the second metal layer, a first interface, a second interface, and a third interface of the third metal layer are wrapped with a first dielectric layer, the first interface is an interface that is of the third metal layer and that faces the first metal layer, the second interface is an interface that is of the third metal layer and that faces the second metal layer, and the third interface is an interface that is of the third metal layer and that faces the semiconductor channel layer. The stacked structure further includes a first contact layer and a second contact layer, the first contact layer is located between the first metal layer and the first dielectric layer, and the second contact layer is located between the second metal layer and the first dielectric layer. The semiconductor channel layer is separately in contact with the first metal layer and the second metal layer.

It should be understood that one of the first metal layer and the second metal layer is a source, the other is a drain, and the third metal layer is a gate. The first dielectric layer may also be referred to as a gate oxygen dielectric layer.

According to the vertical channel transistor provided in this embodiment of this application, the source and the drain are located at a top and a bottom of a device. A gate is located between the source and the drain in a vertical direction. The gate regulates a current in the semiconductor channel layer from an outer side. A gate oxygen dielectric layer is disposed on a surface that is of the gate and that faces the source, a surface that is of the gate and that faces the drain, and a surface that is of the gate and that is close to the semiconductor channel layer. A contact layer is disposed between the drain and the gate oxygen dielectric layer, and a contact layer is also disposed between the source and the gate oxygen dielectric layer, so that the source and the drain separately form ohmic contact with the vertical channel layer. The structure effectively reduces a contact resistance and improves device performance. In addition, in the structure, the gate and the gate oxygen dielectric layer are disposed between the source and the drain, and an insulation dielectric layer is omitted. Therefore, a size of the transistor device may be smaller, to facilitate improvement of integration.

In a possible implementation, the groove penetrates the stacked structure.

In a possible implementation, materials of the first contact layer and the second contact layer are conductor materials, and the conductor materials of the first contact layer and the second contact layer are different from materials of the first metal layer and the second metal layer; or materials of the first contact layer and the second contact layer are semiconductor materials whose conductivities are higher than that of the semiconductor channel layer.

In a possible implementation, a resistance of a contact surface formed between the first contact layer and the semiconductor channel layer and a resistance of a contact surface formed between the second contact layer and the semiconductor channel layer are respectively less than a resistance of a contact surface formed between the first metal layer and the semiconductor channel layer and a resistance of a contact surface formed between the second metal layer and the semiconductor channel layer.

In a possible implementation, a resistance of a contact surface formed between the first contact layer and the first metal layer and a resistance of a contact surface formed between the second contact layer and the second metal layer are less than a first threshold.

In a possible implementation, the structure is in a cylindrical shape. The stacked structure surrounds the semiconductor channel layer, and the semiconductor channel layer is completely located in the vertical groove inside the stacked structure.

In a possible implementation, the structure is in a square columnar shape. The stacked structure includes a first stacked substructure and a second stacked substructure, the semiconductor channel layer is located between the first stacked substructure and the second stacked substructure, and the first semiconductor channel layer is separately in contact with a side surface of the first stacked substructure and a side surface of the second stacked substructure.

The vertical channel transistor includes two vertical channels, thereby increasing an operating current of the vertical channel transistor device, and further increasing an operating speed of a memory in which the vertical channel transistor is located.

In a possible implementation, the first contact layer and the second contact layer are doped semiconductor layers, and a material of the doped semiconductor layer is obtained by doping a material of the semiconductor channel layer.

For an optional specific material of the contact layer, refer to the description in the first aspect. Details are not described herein again.

In a possible implementation, the first contact layer, the second contact layer, and the semiconductor channel layer are all P-type semiconductors or N-type semiconductors; the first contact layer and the second contact layer are N-type semiconductors, and the semiconductor channel layer is a P-type semiconductor; or the first contact layer and the second contact layer are P-type semiconductors, and the semiconductor channel layer is an N-type semiconductor.

It should be understood that, if a material of an ohmic contact layer and a material of the semiconductor channel layer have a same polarity, the ohmic contact may be formed between the source/drain and the semiconductor channel layer after the ohmic contact layer is introduced. If a material of an ohmic contact layer and a material of the semiconductor channel layer have inconsistent polarities, doping concentration of the ohmic contact layer needs to be increased, to form PN junction ohmic contact between the source/drain and the semiconductor channel layer. This expands selection of a device material, this solution can be widely used to optimize a contact resistance of a device made of any material, and this implements a heterogeneous-contact transistor device.

In a possible implementation, the vertical channel transistor structure further includes a first interface layer and a second interface layer, where the first interface layer is located between the first contact layer and the first dielectric layer, and the second interface layer is located between the second contact layer and the first dielectric layer.

In a possible implementation, materials of the first interface layer and the second interface layer are the same as the materials of the first contact layer and the second contact layer, but doping concentration of the materials of the first interface layer and the second interface layer is lower than doping concentration of the materials of the first contact layer and the second contact layer.

The interface layers may be respectively introduced at an interface between the first contact layer and the gate oxygen dielectric layer and an interface between the second contact layer and the gate oxygen dielectric layer, to effectively prevent a heavily doped element from diffusing into the gate oxygen dielectric layer.

A fourth aspect of this application provides a method for manufacturing a vertical channel transistor, where the method includes: sequentially depositing a first metal layer, a first contact layer, an insulation dielectric layer, a second contact layer, and a second metal layer to form a stacked structure; etching the stacked structure to form a first groove; growing a semiconductor channel layer in the first groove to form a second groove; growing a gate oxygen dielectric layer in the second groove to form a third groove; and growing a gate in the third groove. Materials of the first contact layer and the second contact layer are conductor materials or semiconductor materials whose conductivities are higher than that of the semiconductor channel layer.

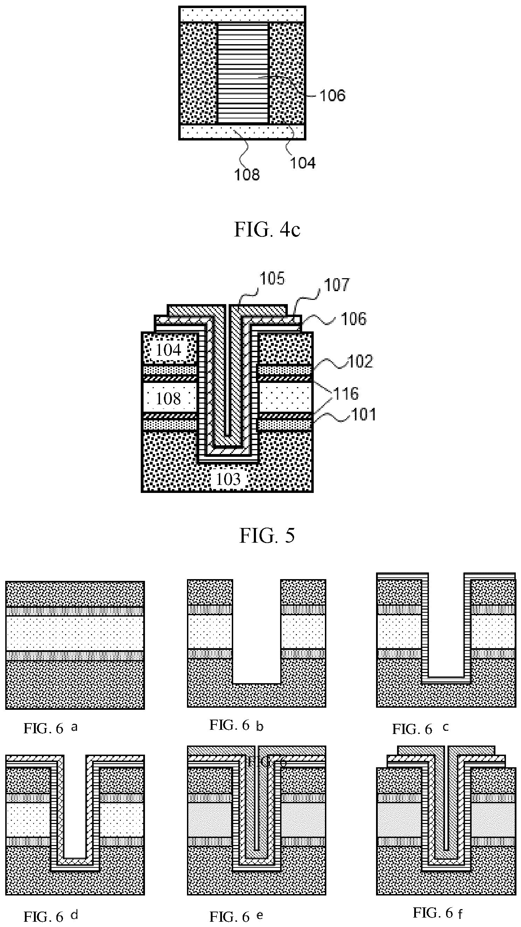

A conventional process is applied to the vertical channel transistor. When a structure shown in FIG. 6b is formed, the source and the drain need to be doped, and then when a structure shown in FIG. 6c is formed, the semiconductor channel layer is doped, to reduce a contact resistance between the source/drain and the semiconductor channel. Because the semiconductor channel layer is perpendicular, doping concentration is uneven in an upper part and a lower part of the semiconductor channel layer when the semiconductor channel layer is bombarded through an ion beam to implement doping, and doping concentration is also uneven in an upper part and a lower part when the source and the drain are doped. In the manufacturing method in this application, an ohmic contact layer is introduced to reduce a contact resistance between the source/drain and the semiconductor channel layer, and the contact resistance does not need to be reduced by doping the source, the drain, and the semiconductor channel layer. Therefore, a problem of uneven doping concentration is avoided, and an additional photomask required for a doping process does not need to be added. The process is simple, and application costs are reduced. Further, in the vertical channel transistor, because source/drain metal is in contact with the semiconductor channel, a contact surface is oxidized to some extent in an annealing process, and oxidation increases the contact resistance. After the contact layer is introduced, even if the metal is oxidized, a contact resistance of the transistor device is not greatly affected. Therefore, negative effect of a contact resistance increase due to oxidation of the contact surface between the metal and the channel caused by subsequent annealing can be avoided, and thermal stability of the device can be improved.

In a possible implementation, after the growing a gate in the gate oxygen dielectric layer, the method further includes: etching the gate, the gate oxygen dielectric layer, and the semiconductor channel layer, to form isolation between the vertical channel transistor and another adjacent vertical channel transistor.

In a possible implementation, a resistance of a contact surface formed between the first contact layer and the semiconductor channel layer and a resistance of a contact surface formed between the second contact layer and the semiconductor channel layer are respectively less than a resistance of a contact surface formed between the first metal layer and the semiconductor channel layer and a resistance of a contact surface formed between the second metal layer and the semiconductor channel layer.

In a possible implementation, the materials of the first contact layer and the second contact layer include titanium Ti, gold Au, tungsten W, molybdenum Mo, aluminum Al, or titanium nitride TiN.

In a possible implementation, the materials of the first contact layer and the second contact layer include indium gallium zinc oxide InGaZnO, indium zinc oxide InZnO, indium tin oxide InSnO, indium oxide In2O3, gallium oxide Ga2O3, indium titanium oxide InTiO, or zinc oxide ZnO.

In a possible implementation, the materials of the first contact layer and the second contact layer include heavily doped P-type silicon Si and N-type Si, or any combination of the P-type silicon Si and the N-type Si.

In a possible implementation, the first contact layer and the second contact layer are doped semiconductor layers, and a material of the doped semiconductor layer is obtained by doping a material of the semiconductor channel layer.

In a possible implementation, when polarities of semiconductors of the first contact layer and the second contact layer are different from a polarity of a semiconductor of the semiconductor channel layer, doping concentration of the first contact layer and the second contact layer is higher than doping concentration of the semiconductor channel layer.

In a possible implementation, the sequentially depositing a first metal layer, a first contact layer, an insulation dielectric layer, a second contact layer, and a second metal layer to form a stacked structure specifically includes: sequentially depositing the first metal layer, the first contact layer, a first interface layer, the insulation dielectric layer, a second interface layer, the second contact layer, and the second metal layer to form the stacked structure.

In this embodiment of this application, when the vertical channel transistor including the interface layer is manufactured, the interface layer can effectively prevent a heavily doped element from diffusing into the insulation dielectric layer, thereby expanding a doping concentration window of the contact layer. The contact layer can be doped at higher concentration, so that a resistance of formed PN junction ohmic contact is smaller. In addition, when the first contact layer and the second contact layer are heavily doped, the heavily doped element can be prevented from diffusing into the insulation isolation layer, and isolation effect of the insulation isolation layer is not affected.

In a possible implementation, a process of growing the semiconductor channel layer, the gate oxygen dielectric layer, and the gate includes atomic layer deposition (Atomic Layer Deposition, ALD) or chemical vapor deposition (Chemical Vapor Deposition, CVD).

A fifth aspect of this application provides a method for manufacturing a vertical channel transistor, where the method includes: sequentially depositing a first metal layer, a first contact layer, an insulation dielectric layer, a second contact layer, and a second metal layer to form a stacked structure; etching the stacked structure to form a via hole; growing a semiconductor channel layer in the via hole; removing the insulation dielectric layer from the stacked structure through wet etching; and successively growing a gate oxygen dielectric layer and a gate in a space formed after the insulation dielectric layer is removed.

In the manufacturing method in this application, an ohmic contact layer is introduced to reduce a contact resistance between a source/drain and the semiconductor channel layer, and the contact resistance does not need to be reduced by doping the source, the drain, and the semiconductor channel layer. Therefore, a problem of uneven doping concentration is avoided, and an additional photomask required for a doping process does not need to be added. The process is simple, and application costs are reduced. Further, in the vertical channel transistor, because source/drain metal is in contact with the semiconductor channel, a contact surface is oxidized to some extent in an annealing process, and oxidation increases the contact resistance. After the contact layer is introduced, even if the metal is oxidized, a contact resistance of the transistor device is not greatly affected. Therefore, negative effect of a contact resistance increase due to oxidation of the contact surface between the metal and the channel caused by subsequent annealing can be avoided, and thermal stability of the device can be improved.

In a possible implementation, a resistance of a contact surface formed between the first contact layer and the semiconductor channel layer and a resistance of a contact surface formed between the second contact layer and the semiconductor channel layer are respectively less than a resistance of a contact surface formed between the first metal layer and the semiconductor channel layer and a resistance of a contact surface formed between the second metal layer and the semiconductor channel layer.

In a possible implementation, a resistance of a contact surface formed between the first contact layer and the first metal layer and a resistance of a contact surface formed between the second contact layer and the second metal layer are less than a first threshold.

In a possible implementation, materials of the first contact layer and the second contact layer are conductor materials, and the conductor materials of the first contact layer and the second contact layer are different from materials of the first metal layer and the second metal layer; or materials of the first contact layer and the second contact layer are semiconductor materials whose conductivities are higher than that of the semiconductor channel layer.

In a possible implementation, the first contact layer and the second contact layer are doped semiconductor layers, and a material of the doped semiconductor layer is obtained by doping a material of the semiconductor channel layer.

In a possible implementation, when polarities of semiconductors of the first contact layer and the second contact layer are different from a polarity of a semiconductor of the semiconductor channel layer, doping concentration of the first contact layer and the second contact layer is higher than doping concentration of the semiconductor channel layer.

In a possible implementation, the sequentially depositing a first metal layer, a first contact layer, an insulation dielectric layer, a second contact layer, and a second metal layer to form a stacked structure includes: sequentially depositing the first metal layer, the first contact layer, a first interface layer, the insulation dielectric layer, a second interface layer, the second contact layer, and the second metal layer to form the stacked structure.

When the stacked structure is manufactured, the interface layers may be respectively formed between the first contact layer and the dielectric layer and between the second contact layer and the dielectric layer, to manufacture and obtain the vertical channel transistor including the interface layer. This effectively prevents a heavily doped element from diffusing into the dielectric layer, thereby expanding a doping concentration window of the contact layer.

### BRIEF DESCRIPTION OF DRAWINGS

FIG. 1 is a diagram of comparison between a conventional vertical channel transistor and a vertical channel transistor provided in embodiments of this application according to an embodiment of this application;
FIG. 2a is a diagram of a structure of a vertical channel transistor according to an embodiment of this application;
FIG. 2b is a partially enlarged view of FIG. 2a;
FIG. 2c is a sectional view of FIG. 2b along a dashed line 110;
FIG. 3a is a top view of an example of a vertical channel transistor according to an embodiment of this application;
FIG. 3b is a top view of another example of a vertical channel transistor according to an embodiment of this application;
FIG. 4a is side cross-sectional view of an example of a vertical channel transistor according to an embodiment of this application;
FIG. 4b is a top view corresponding to the vertical channel transistor in FIG. 4a;
FIG. 4c is another top view corresponding to the vertical channel transistor in FIG. 4a;
FIG. 5 is a diagram of a structure of another vertical channel transistor according to an embodiment of this application;
FIG. 6a to FIG. 6f are a schematic flowchart of a manufacturing process of a vertical channel transistor according to an embodiment of this application;
FIG. 7 is a schematic flowchart of a method for manufacturing a vertical channel transistor according to an embodiment of this application;
FIG. 8 is a schematic flowchart of another method for manufacturing a vertical channel transistor according to an embodiment of this application;
FIG. 9a to FIG. 9e are a schematic flowchart of another manufacturing process of a vertical channel transistor according to an embodiment of this application; and
FIG. 10 is a schematic flowchart of another method for manufacturing a vertical channel transistor according to an embodiment of this application.

### DESCRIPTION OF EMBODIMENTS

In embodiments of the specification, claims, and accompanying drawings of this application, the terms "first", "second", and the like are intended to distinguish between similar objects but do not necessarily indicate a specific order or sequence. In addition, the terms "include", "have", or any other variant thereof are intended to cover a non-exclusive inclusion, for example, a series of steps or units. For example, a method, system, product, or device is not necessarily limited to those steps or units expressly listed, but may include other steps or units not expressly listed or inherent to such a process, method, product, or device.

It should be understood that in this application, "at least one piece (item)" means one or more and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" usually indicates an "or" relationship between the associated objects. "At least one of the following items (pieces)" or a similar expression thereof means any combination of these items, including any combination of singular items (pieces) or plural items (pieces). For example, at least one item (piece) of a, b, or c may indicate a, b, c, "a and b", "a and c", "b and c", or "a, b, and c", where a, b, and c may be singular or plural.

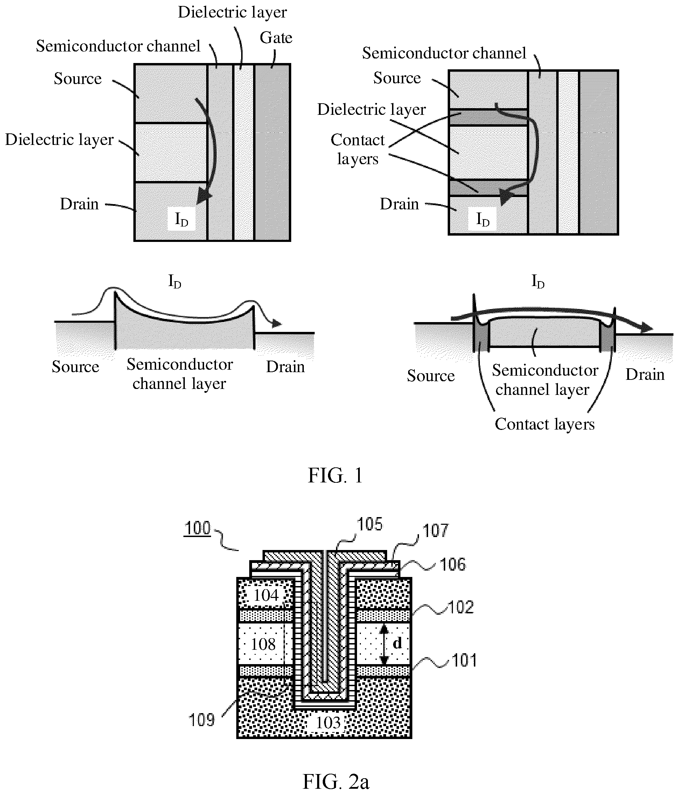

A vertical channel transistor in the conventional technology usually has a problem of a large contact resistance. This greatly affects electrical performance of the transistor. As shown in FIG. 1, a diagram of a structure of a conventional vertical channel transistor and a corresponding band diagram (band diagram) are at a left side, and a diagram of a vertical channel transistor having a contact layer and a corresponding band diagram according to an embodiment of this application are at a right side. As shown at the left side of FIG. 1, in the conventional technology, electrons need to pass through two contact surfaces from a source to a semiconductor channel layer and then to a drain: a contact surface between the source and the semiconductor channel layer and a contact surface between the semiconductor channel layer and the drain. Both contact between the source and the semiconductor channel layer and contact between the semiconductor channel layer and the drain are Schottky contact, and a thermal excitation mode is used for current injection. As a result, a contact resistance is large, electronic potential energy required for passing through a barrier is large, and a current is small. A vertical channel transistor structure provided in this application is shown at the right side of FIG. 1. Contact layers are respectively disposed between a drain and an insulation dielectric layer and between a source and the insulation dielectric layer. Electrons need to pass through four contact surfaces in total from the source to the drain: a contact surface between the source and a first contact layer, a contact surface between the first contact layer and a semiconductor channel layer, a contact surface between the semiconductor channel layer and a second contact layer, and a contact surface between the second contact layer and the drain. Because materials of the two contact layers are conductor materials or semiconductor materials whose conductivities are higher than that of the semiconductor channel layer, and resistances are low, performance of contact between the contact layer and the semiconductor channel layer is far better than performance of contact between the source and the semiconductor channel layer and contact between the drain and the semiconductor channel layer, a contact resistance of the contact surface between the contact layer and the semiconductor channel layer is far less than a contact resistance of the contact surface between the source and the semiconductor channel layer and a contact resistance of the contact surface between the drain and the semiconductor channel layer. In addition, because the contact layer is in good contact with metal, in an ideal case, contact resistances formed between the source and the contact layer and between the drain and the contact layer may be ignored. Therefore, after the two contact layers are introduced, a total resistance of the four contact surfaces through which the electrons pass from the source to the drain is less than a total resistance of the two contact surfaces through which the electrons pass from the source to the drain in the conventional technology, so that ohmic contact (which may also be referred to as ohmic-like contact) can be formed between the source and the semiconductor channel layer and between the drain and the semiconductor channel layer. When the vertical channel transistor with this structure operates, the electrons may, through a barrier due to fluctuation, directly enter the semiconductor channel layer from the source and enter the drain from the semiconductor channel layer, that is, tunneling injection of a current is implemented. Compared with a vertical channel transistor in which the contact layer is not disposed, in the vertical channel transistor in this embodiment, a contact resistance of the vertical channel transistor is greatly reduced, and a current flowing from the source to the drain is increased, that is, an operating current of the vertical channel transistor is increased.

It should be understood that the contact resistance in this embodiment of this application may be understood as a sum of a resistance Rs between the source and the channel and a resistance Rd between the channel and the drain. It should be understood that the contact resistance and the sum of Rs and Rd may be only approximate, but not necessarily strictly equal. The contact resistance may also be referred to as a source-drain contact resistance.

An embodiment of this application provides a vertical channel transistor structure. The structure includes a stacked structure. The stacked structure includes a first metal layer, a first contact layer, an insulation dielectric layer, a second contact layer, and a second metal layer. The first contact layer is located between the first metal layer and the insulation dielectric layer, and the second contact layer is located between the second metal layer and the insulation dielectric layer. A groove is disposed in the stacked structure. A semiconductor channel layer, a gate oxygen dielectric layer, and a gate are disposed in the groove. The semiconductor channel layer is separately in contact with the first metal layer and the second metal layer, and the gate oxygen dielectric layer is disposed between the semiconductor channel layer and the gate.

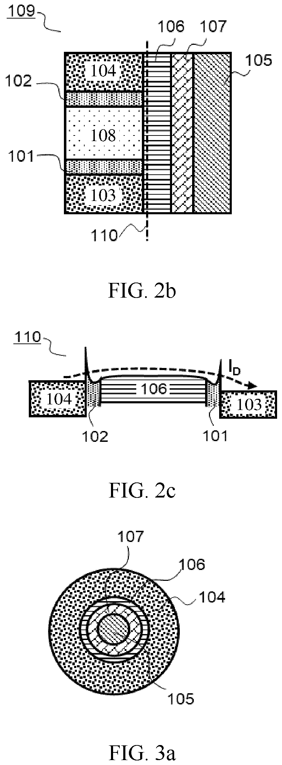

FIG. 2a is a diagram of a structure of a vertical channel transistor according to an embodiment of this application, FIG. 2b is a partially enlarged view of FIG. 2a, and FIG. 2c is a sectional view of FIG. 2b along a dashed line 110. Based on FIG. 2a to FIG. 2c, it can be seen that the vertical channel transistor includes a drain (Drain) 103, a source (Source) 104, a gate (Gate) 105, a semiconductor channel layer 106, a gate oxygen dielectric layer 107, and an insulation dielectric layer 108, a first contact layer 101, and a second contact layer 102. The vertical channel transistor is of a columnar structure, and has a semiconductor channel in a vertical direction. The drain 103, the first contact layer 101, the insulation dielectric layer 108, the second contact layer 102, and the source 104 form a stacked structure in the vertical direction, where a deep hole or groove is disposed inside the stacked structure, the semiconductor channel layer 106, the gate oxygen dielectric layer 107, and the gate 105 are sequentially disposed in the deep hole, the semiconductor channel layer 106 forms contact with both the source 104 and the drain 103, and the gate oxygen dielectric layer 107 is disposed between the gate 105 and the semiconductor channel layer 106. It should be understood that locations of the source 104and the drain 103 may be interchanged. In FIG. 2a, the drain is at a lower side of the device, and the source is at an upper side of the device. In an optional case, the source is at a lower side of the device, and the drain is at an upper side of the device. The locations of the source and the drain are not limited in embodiments of this application. For example, the vertical channel transistor in this embodiment of this application may be a vertical channel TFT.

For example, the deep hole in the stacked structure penetrates the source layer 104, the second contact layer 102, the insulation dielectric layer 108, and the first contact layer 101, and is recessed into the drain 103. Usually, the insulation dielectric layer 108 is disposed between the drain 103 and the source 104, so that electrical isolation between source metal and drain metal can be implemented.

In this embodiment of this application, the first contact layer 101 is disposed between the drain 103 and the insulation dielectric layer 108, and the second contact layer 102 is disposed between the source 104 and the insulation dielectric layer 108. The two contact layers each have a low resistance and a high doping concentration, and are in good contact with metal, so that ohmic contact (which may also be referred to as ohmic-like contact) may be formed between the source 104 and the semiconductor channel layer 106, and between the drain 103 and the semiconductor channel layer 106. When the vertical channel transistor with this structure operates, electrons may, through a barrier due to fluctuation, directly enter the semiconductor channel layer from the source and enter the drain from the semiconductor channel layer, that is, tunneling injection of a current is implemented. Compared with a vertical channel transistor in which the first contact layer 101 and the second contact layer 102 are not disposed, in the vertical channel transistor in this embodiment, a contact resistance of the vertical channel transistor is greatly reduced, and a current flowing from the source to the drain is increased, that is, an operating current of the vertical channel transistor is increased.

It should be understood that the insulation dielectric layer may also be referred to as a dielectric layer. A length of the vertical channel is determined based on a thickness d of the insulation dielectric layer. To some extent, the length of the vertical channel is approximately equal to the thickness d of the insulation dielectric layer.

It should be understood that the first contact layer 101 and the second contact layer 102 each may also be referred to as a transition layer, an ohmic contact layer, or an ohmic contact intercalation layer. Names of the contact layers are not limited in embodiments of this application. For example, materials of the first contact layer and the second contact layer are conductor materials or semiconductor materials whose conductivities are higher than that of the semiconductor channel layer. If the materials of the first contact layer and the second contact layer are the conductor materials, the conductor materials of the first contact layer and the second contact layer are different from materials of the first metal layer and the second metal layer. The materials of the first contact layer and the second contact layer can form good contact with the semiconductor channel layer. Therefore, a contact resistance of a contact surface between the contact layer and the semiconductor channel layer is far less than a contact resistance of a contact surface between the source and the semiconductor channel layer and a contact resistance of a contact surface between the drain and the semiconductor channel layer. In addition, because the contact layer is in good contact with the metal, a resistance of a contact surface formed between the first contact layer and the first metal layer and a resistance of a contact surface formed between the second contact layer and the second metal layer are less than a first threshold. Ideally, the first threshold is close to 0. Therefore, the resistance of the contact surface formed between the contact layer and the metal layer may be ignored.

In a possible implementation, a sum of the resistance of the contact surface formed between the first contact layer and the first metal layer and a resistance of a contact surface formed between the first contact layer and the semiconductor channel layer is less than a resistance of a contact surface formed between the first metal layer and the semiconductor channel layer. A sum of the resistance of the contact surface formed between the second contact layer and the second metal layer and a resistance of a contact surface formed between the second contact layer and the semiconductor channel layer is less than a resistance of a contact surface formed between the second metal layer and the semiconductor channel layer.

The materials of the first contact layer and the second contact layer are related to a material of the semiconductor channel layer.

For example, when the materials of the first contact layer and the second contact layer are the conductor materials, if the semiconductor channel layer is an N-type semiconductor, the materials of the first contact layer and the second contact layer are first conductor materials, where a work function of the first conductor material is less than or close to electron affinity of the semiconductor channel layer; or if the semiconductor channel layer is a P-type semiconductor, the materials of the first contact layer and the second contact layer are second conductor materials, where a work function of the second conductor material is greater than or close to a sum of electron affinity and a band gap of the semiconductor channel layer.

For example, when the materials of the first contact layer and the second contact layer are the semiconductor materials, if the semiconductor channel layer is a first N-type semiconductor, the materials of the first contact layer and the second contact layer are first semiconductor materials, where a conduction band location of the first semiconductor material is close to a conduction band location of the first N-type semiconductor, and a conductivity of the first semiconductor material is greater than or equal to a conductivity of the first N-type semiconductor; or if the semiconductor channel layer is a first P-type semiconductor, the materials of the first contact layer and the second contact layer are second semiconductor materials, where a valence band location of the second conductor material is close to a valence band location of the first P-type semiconductor, and a conductivity of the second conductor material is greater than or equal to a conductivity of the first P-type semiconductor.

The following describes definitions of several terms in embodiments of this application.

Work function (work function): The work function is minimum energy that needs to be provided to enable an electron to escape from a surface of a solid immediately. Generally, a unit is electron volt. Here, the term "immediately" indicates that a final electron location is far away from the surface at an atomic scale but still close to the solid at a macroscopic scale. The work function is an important attribute of metal.

Electron affinity (electron affinity): The electron affinity may also be referred to as electron affinity potential or electron affinity and is energy of the affinity between electrons. The electron affinity is energy released when a gaseous atom in a ground state obtains an electron to become a gaseous anion. A unit is kJ/mol. The electron affinity indicates energy consumed or released to separate an electron from a gaseous ion or molecule.

Conduction band (conduction band): The conduction band is an energy space formed by a free electron, namely, an energy range of the electron moving freely in a solid structure.

Valence band (valence band): The valence band is a highest-energy region in which an electron in a solid at absolute zero is located. If an electron in the valence band is given energy higher than a band gap, the electron transits from the valence band to a conduction band. In short, a band occupied by valence electrons is the valence band.

Forbidden band (forbidden band): The forbidden band usually indicates an energy range whose density of states is zero between a valence band and a conduction band. A gap between the conduction band and the valence band is the forbidden band.

Band gap (band gap or width of forbidden band): The band gap indicates an energy range of a forbidden band. To become a free electron or a hole, a bound electron needs to obtain enough energy to transit from a valence band to a conduction band. A minimum value of this energy is the band gap. In other words, the band gap is energy between a lowest energy level of the conduction band and a highest energy level of the valence band.

For example, a contact layer may use a same semiconductor as a semiconductor channel, but the semiconductor at the contact layer needs to be doped or processed in another way, so that the contact layer has a lower resistance than the semiconductor channel layer. When the first contact layer and the second contact layer are semiconductors, the first contact layer and the second contact layer may also be referred to as doped semiconductor layers.

In embodiments of this application, an ohmic contact layer is introduced, so that in a condition that an area of a transistor device is not increased, a contact area between a channel and a source/drain can be increased, to effectively reduce a contact resistance, and a threshold of a channel material is kept unchanged, to improve device performance.

For example, based on a material of a semiconductor channel layer, a source metal material, and a drain metal material, a first contact layer 101 and a second contact layer 102 each may select a highly conductive oxide semiconductor, for example, indium gallium zinc oxide InGaZnO, indium zinc oxide InZnO, indium tin oxide InSnO, indium oxide In2O3, gallium oxide Ga2O3, indium titanium oxide InTiO, and zinc oxide ZnO, may select a conductor, for example, titanium Ti, gold Au, tungsten W, molybdenum Mo, aluminum Al, and titanium nitride TiN, or may select heavily doped P-type silicon Si and N-type Si, or any combination of the P-type silicon Si and the N-type Si.

A source 104 and a drain 103 may use a metal material or a conductive material, for example, TiN, Ti, Au, W, Mo, In-Ti-O (ITO), Al, copper Cu, ruthenium Ru, silver Ag, or any combination thereof.

A gate 105 may be made of a metal material or a conductive material, for example, TiN, Ti, Au, W, Mo, InTiO, InZnO, Al, Cu, Ru, Ag, or any combination thereof.

A material of a gate oxygen dielectric layer 107 may be an insulation material such as SiO2, Al2O3, HfO2, ZrO2, TiO2, Y2O3, LaOx, or Si3N4, or any combination material thereof. The gate oxygen dielectric layer 107 may be of a stacked structure of a single material or a stacked structure of a combination material.

The material of the semiconductor channel layer 106 may be Si, polysilicon poly-Si, amorphous silicon amorphous-Si, a multi-composite compound such as IGZO, a semiconductor material such as In2O3, Ga2O3, ZnO, SnOx, ITO, TiO2, and MoS2, or any combination thereof.

A material of the insulation dielectric layer 108 may be a material such as SiO2, Si3N4, or Al2O3.

The vertical channel thin film transistor provided in embodiments of this application may be of a cylindrical structure or a square columnar structure. FIG. 3a is a top view of an example of a vertical channel transistor according to an embodiment of this application. The vertical channel transistor is cylindrical. An innermost layer of the cylinder is a gate 105, the gate 105 is wrapped with a gate oxygen dielectric layer 107, the gate oxygen dielectric layer is wrapped with a semiconductor channel layer 106, and an outer layer of the semiconductor channel layer 106 is wrapped with a stacked structure formed by a source layer, a drain layer, and the like. Because FIG. 3a is the top view, only the source layer 104 at a top layer can be seen. This implementation is a channel-all-around (Channel-All-Around, CAA) manner. The semiconductor channel layer 106 is completely filled in a vertical groove inside the stacked structure.

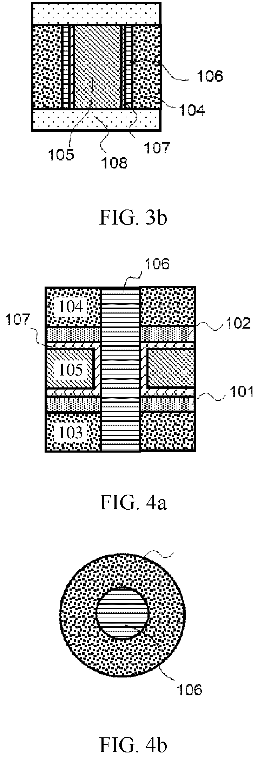

FIG. 3b is a top view of another example of a vertical channel transistor according to an embodiment of this application. In this implementation, the vertical channel transistor is of a double-channel structure, and the vertical channel transistor is of a square columnar structure. Therefore, the top view of the vertical channel transistor is rectangular, an entire stacked structure formed by a drain 103, a first contact layer 101, an insulation dielectric layer 108, a second contact layer 102, and a source 104 in a vertical direction is the square columnar structure, or may be referred to as a cube. It should be explained that, because the drain 103, the first contact layer 101, the insulation dielectric layer 108, and the second contact layer 102 are all located below the source 104, only the topmost source 104 can be seen in the top view 3b. After a middle part of the stacked structure is etched, two side walls remain, and a semiconductor channel layer 106, a gate oxygen dielectric layer 107, and a gate 105 are sequentially disposed on an inner side of each of the two side walls. The two semiconductor channel layers 106 are disposed close to the two side walls of the transistor, thereby generating two perpendicular channels. For example, the two side walls are respectively referred to as a first stacked substructure and a second stacked substructure, and a gate is disposed between the first stacked substructure and the second stacked substructure. A first semiconductor channel layer and a first gate oxygen dielectric layer are disposed between the first stacked substructure and the gate, and the first semiconductor channel layer is in contact with a side surface of the first stacked substructure. A second semiconductor channel layer and a second gate oxygen dielectric layer are disposed between the second stacked substructure and the gate, and the second semiconductor channel layer is in contact with a side surface of the second stacked substructure. The first semiconductor channel layer is in contact with the side surface of the first stacked substructure to form one vertical channel, and the second semiconductor channel layer is in contact with the side surface of the second stacked substructure to form the other vertical channel. Therefore, the vertical channel transistor has two vertical channels.

The double-channel structure can further increase an operating current of the vertical channel transistor device, and further increase an operating speed of a memory in which the vertical channel transistor is located.

It should be understood that the two insulation dielectric layers 108 shown in FIG. 3b are configured to isolate adjacent vertical channel transistors, and are not a part of the vertical channel transistors. The insulation dielectric layers in FIG. 3a and FIG. 3b each may have a side view shown in FIG. 2a. In other words, FIG. 3a and FIG. 3b may be two possible top views corresponding to the side view of the vertical channel transistor shown in FIG. 2a.

It should be understood that, in an optional case, a square deep hole may also be disposed inside the square columnar structure, and the semiconductor channel layer 106, the gate oxygen dielectric layer 107, and the gate 105 are sequentially disposed in the square deep hole. In this structure, the semiconductor channel layer 106 is located inside the square column, the semiconductor channel layer 106 completely wraps the gate oxygen dielectric layer 107, and the gate oxygen dielectric layer also completely wraps the gate 105.

In an optional case, a cross-sectional view of the vertical channel transistor in a top view direction may also be another shape except for a circle and a square, for example, may be a polygon, a sector, or an irregular shape.

Further, an embodiment of this application further provides a vertical channel transistor, including a stacked structure and a semiconductor channel layer, where the stacked structure is provided with a vertical groove, and the semiconductor channel layer is disposed in the groove. The stacked structure includes a first metal layer, a second metal layer, and a third metal layer, the third metal layer is located between the first metal layer and the second metal layer, a first interface, a second interface, and a third interface of the third metal layer are wrapped with a first dielectric layer, the first interface is an interface that is of the third metal layer and that faces the first metal layer, the second interface is an interface that is of the third metal layer and that faces the second metal layer, and the third interface is an interface that is of the third metal layer and that faces the semiconductor channel layer. The stacked structure further includes a first contact layer and a second contact layer, the first contact layer is located between the first metal layer and the first dielectric layer, and the second contact layer is located between the second metal layer and the first dielectric layer. The semiconductor channel layer is separately in contact with the first metal layer and the second metal layer. It should be understood that one of the first metal layer and the second metal layer is a source, the other is a drain, and the third metal layer is a gate. The first dielectric layer may also be referred to as a gate oxygen dielectric layer. It should be understood that for the first contact layer and the second contact layer in this embodiment of this application, refer to the foregoing descriptions. Details are not described herein again.

FIG. 4a is a side cross-sectional view of another vertical channel transistor according to an embodiment of this application. FIG. 4b is a top view corresponding to the vertical channel transistor in FIG. 4a. FIG. 4c is another top view corresponding to the vertical channel transistor in FIG. 4a.

In the vertical channel transistor shown in FIG. 4a, a vertical channel layer 106 is fully filled in a vertical channel in a stacked structure, and the channel penetrates the entire stacked structure. A source 104 and a drain 103 are located at the top and the bottom of the device respectively. A gate 105 is located between the source 104 and the drain 103 in a vertical direction. The gate 105 regulates a current in the semiconductor channel layer 106 from an outer side. A gate oxygen dielectric layer 107 is disposed on a surface that is of the gate 105 and that faces the source 104, a surface that is of the gate and that faces the drain 103, and a surface that is of the gate and that is close to the semiconductor channel layer. A first contact layer 101 is located between the drain 103 and the gate oxygen dielectric layer 107, and a second contact layer 102 is located between the source 104 and the gate oxygen dielectric layer 107, so that the source and the drain separately form ohmic contact with the vertical channel layer 106. The structure effectively reduces a contact resistance and improves device performance. In addition, in the structure, the gate and the gate oxygen dielectric layer are disposed between the source 104 and the drain 103, and an insulation dielectric layer 108 is omitted. Therefore, a size of the transistor device may be smaller, to facilitate improvement of integration.

As shown in FIG. 4b, the vertical channel transistor shown in FIG. 4a may be made into a cylindrical structure. This implementation is a GAA manner, and the vertical channel layer 106 is completely filled in the vertical channel in the stacked structure, and is wrapped with the source 104, the drain 103, and the gate 105 that are surrounded in a horizontal direction.

As shown in FIG. 4c, the vertical channel transistor shown in FIG. 4a may be made into a square columnar structure, and the entire stacked structure formed by the drain 103, the first contact layer 101, the gate 105, the gate oxygen dielectric layer 107, the second contact layer 102, and the source 104 in the vertical direction is the square columnar structure, or may be referred to as a cube structure. It should be explained that, because the drain 103, the first contact layer 101, the gate 105, the gate oxygen dielectric layer 107, and the second contact layer 102 are all located below the source 104, only the topmost source 104 can be seen in the top view 4c. Two side walls remain after a middle part of the stacked structure is etched. The semiconductor channel layer 106 is disposed between the two side walls. The source 104 and the drain 103 are located at the top and the bottom of the vertical channel transistor device respectively. The gate 105 is located between the source 104 and the drain 103, and the semiconductor channel layer 106 extends in the vertical direction. Therefore, the structure shown in FIG. 4c is a double-gate structure, and a vertical channel is generated on each of two surfaces that are of the semiconductor channel layer 106 and that are in contact with the stacked structure.

It should be understood that two insulation dielectric layers 108 shown in FIG. 4c are configured to isolate adjacent vertical channel transistors, and are not a part inside the vertical channel transistors.

It should be understood that the cylindrical structure shown in FIG. 4b may also be made into a square columnar structure, and a cross-sectional view of the vertical channel transistor shown in FIG. 4a in a top view direction may also be another shape except for a circle and a square, for example, may be a polygon, a sector, or an irregular shape.

It should be understood that, if a material of an ohmic contact layer and a material of the semiconductor channel layer have a same polarity, the ohmic contact may be formed between the source/drain and the semiconductor channel layer after the ohmic contact layer is introduced. If a material of an ohmic contact layer and a material of the semiconductor channel layer have inconsistent polarities, doping concentration of the ohmic contact layer needs to be increased, to form PN junction ohmic contact between the source/drain and the semiconductor channel layer.

Materials of the first contact layer 101 and the second contact layer 102 may be selected based on the material of the semiconductor channel layer, to implement the PN junction ohmic contact. If the semiconductor channel material is an N-type semiconductor, the first contact layer 101 and the second contact layer 102 may use a P-type semiconductor to form PN junction contact. If the semiconductor channel material is a P-type semiconductor, the first contact layer 101 and the second contact layer 102 may use an N-type semiconductor to form PN junction contact. Further, a contact resistance of a PN junction is reduced by increasing doping concentration of the first contact layer 101 and the second contact layer 102, to form the PN junction ohmic contact between the source/drain and the semiconductor channel layer. This expands selection of a device material, this solution can be widely used to optimize a contact resistance of a device made of any material, and this implements a heterogeneous-contact transistor device.

FIG. 5 is a diagram of a structure of another vertical channel transistor according to an embodiment of this application. In this implementation, interface layers 116 are respectively added between a first contact layer 101 and an insulation dielectric layer 108, and between a second contact layer 102 and the insulation dielectric layer 108. For example, the interface layer 116 may use a material that is the same as materials of the first contact layer 101 and the second contact layer 102. However, doping concentration of the material of the interface layer 116 is different from that of the materials of the first contact layer 101 and the second contact layer 102, doping concentration of the first contact layer 101 and the second contact layer 102 is high, and doping concentration of the interface layer 116 is low.

The interface layers 116 can effectively prevent heavily doped elements from diffusing into the insulation dielectric layer 108, thereby expanding doping concentration windows of the contact layer 101 and the contact layer 102. The contact layer 101 and the contact layer 102 may be doped at higher concentration, so that resistances of formed PN junction ohmic contact are smaller. In addition, when the first contact layer 101 and the second contact layer 102 are heavily doped (or the doping concentration is increased), the heavily doped element can be prevented from diffusing into the insulation isolation layer 108, and isolation effect of the insulation isolation layer 108 is not affected.

In an optional case, the interface layer 116 may also be introduced into the vertical channel transistor shown in FIG. 4a. Specifically, the interface layers may be respectively introduced at an interface between the first contact layer 101 and the gate oxygen dielectric layer 107 and an interface between the second contact layer 102 and the gate oxygen dielectric layer 107, to effectively prevent the heavily doped element from diffusing into the gate oxygen dielectric layer 107.

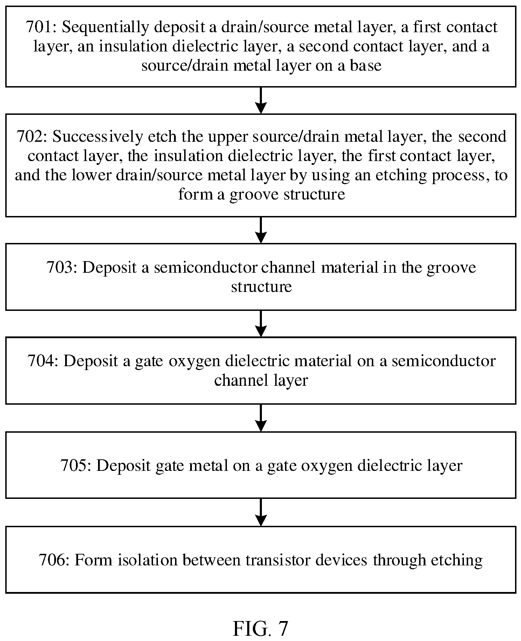

FIG. 6a to FIG. 6f are a schematic flowchart of a manufacturing process of a vertical channel transistor according to an embodiment of this application. FIG. 7 is a schematic flowchart of a method for manufacturing a vertical channel transistor according to an embodiment of this application.

The method includes the following steps.

701: Sequentially deposit (deposit) a drain/source metal layer, a first contact layer, an insulation dielectric layer, a second contact layer, and a source/drain metal layer on a base, to obtain a five-layer structure shown in FIG. 6a.

For example, the base may also be referred to as a substrate, and a material of the base may be an insulation material such as silicon oxide. It should be understood that locations of a source and a drain may be interchanged. If a drain layer is located at a lower part, a source layer is located at an upper part. On the contrary, if a source layer is located at a lower part, a drain layer is located at an upper part. The first contact layer and the second contact layer may be low-resistance semiconductors. For materials of the five layers, refer to the foregoing descriptions of the materials of the source 104, the drain 103, the insulation dielectric layer 108, the first contact layer 101, and the second contact layer 102. Details are not described herein again.

In an optional solution, a first interface layer may be further grown between the first contact layer and the insulation dielectric layer, and a second interface layer may be grown between the second contact layer and the insulation dielectric layer. For materials of the first interface layer and the second interface layer, refer to the foregoing description of the interface layer 116. Details are not described herein again.

702: Successively etch the upper source/drain metal layer, the second contact layer, the insulation dielectric layer, the first contact layer, and the lower drain/source metal layer by using an etching process, to form a groove structure shown in FIG. 6b. For example, a groove shown in FIG. 6b may be referred to as a first groove.

It should be understood that etching is one-step etching. The etching process may use dry etching or wet etching.

703: Deposit a semiconductor channel material in the groove structure to form a structure shown in FIG. 6c. For example, a groove in FIG. 6c may be referred to as a second groove.

For example, a semiconductor channel layer may be grown by using an atomic layer deposition (Atomic Layer Deposition, ALD) process or a chemical vapor deposition (Chemical Vapor Deposition, CVD) process. For the semiconductor channel material, refer to the foregoing description of the semiconductor channel material 106. Details are not described herein again.

704: Deposit a gate oxygen dielectric material based on the structure shown in FIG. 6c to form a structure shown in FIG. 6d. For example, a groove in FIG. 6d may be referred to as a third groove.

For example, the gate oxygen dielectric layer may also be grown by using the ALD process or the CVD process. For the gate oxygen dielectric material, refer to the foregoing description of the material of the gate oxygen dielectric layer 107. Details are not described herein again.

705: Deposit gate metal on the gate oxygen dielectric layer in the third groove to form a structure shown in FIG. 6e.

The gate metal is filled in the third groove in FIG. 6d to form a gate. For example, a gate layer may also be grown by using the ALD process or the CVD process.

706: Form isolation between vertical channel transistor devices through etching, to form a structure shown in FIG. 6f.

In an optional solution, 701 specifically includes: sequentially growing the metal layer, the first contact layer, the first interface layer, the insulation dielectric layer, the second interface layer, the second contact layer, and the metal layer on the base to obtain a seven-layer structure, to manufacture the vertical channel transistor shown in FIG. 5.

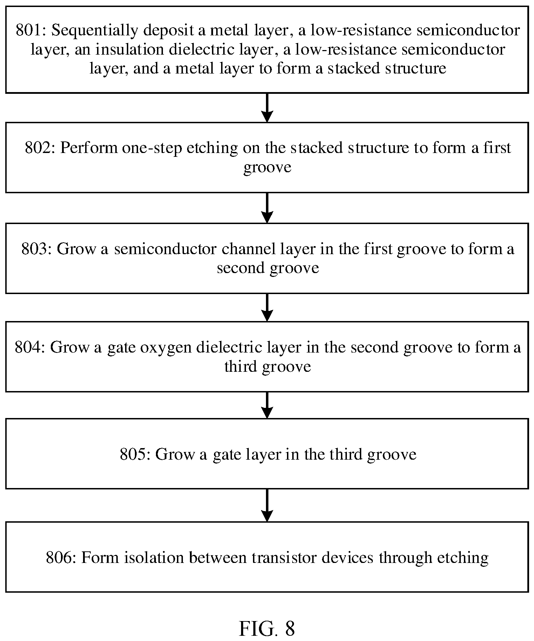

FIG. 8 is a schematic flowchart of another method for manufacturing a vertical channel transistor according to an embodiment of this application.

801: Sequentially deposit a metal layer, a low-resistance semiconductor layer, an insulation dielectric layer, a low-resistance semiconductor layer, and a metal layer, to form a stacked structure shown in FIG. 6a.

802: Perform one-step etching on the stacked structure to form a first groove, as shown in FIG. 6b.

The groove penetrates the upper metal layer, the low-resistance semiconductor layer, the insulation dielectric layer, and the low-resistance semiconductor layer, and is recessed into the lower metal layer.

803: Grow a semiconductor channel layer in the first groove to form a second groove, as shown in FIG. 6c, where the second groove is a groove in which the semiconductor channel layer is grown.

804: Grow a gate oxygen dielectric layer in the second groove to form a third groove, as shown in FIG. 6d, where the third groove is a groove in which the gate oxygen dielectric layer is grown.

805: Grow a gate layer in the third groove to form a structure shown in FIG. 6e.

806: Form isolation between adjacent vertical channel transistors through etching, as shown in FIG. 6f.

It should be understood that the semiconductor channel layer, the gate oxygen dielectric layer, and the gate layer may be all grown by using an ALD process or a CVD process.

In an optional solution, 801 specifically includes: sequentially depositing the metal layer, the first contact layer, the first interface layer, the insulation dielectric layer, the second interface layer, the second contact layer, and the metal layer to obtain a stacked structure including seven layers, to manufacture the vertical channel transistor shown in FIG. 5.

A conventional process is applied to the vertical channel transistor. When the structure shown in FIG. 6b is formed, the source and the drain need to be doped, and then when the structure shown in FIG. 6c is formed, the semiconductor channel layer is doped, to reduce a contact resistance between the source/drain and the semiconductor channel. Because the semiconductor channel layer is perpendicular, doping concentration is uneven in an upper part and a lower part of the semiconductor channel layer when the semiconductor channel layer is bombarded through an ion beam to implement doping, and doping concentration is also uneven in an upper part and a lower part when the source and the drain are doped. In the manufacturing method in this application, an ohmic contact layer is introduced to reduce the contact resistance between the source/drain and the semiconductor channel layer, and the contact resistance does not need to be reduced by doping the source, the drain, and the semiconductor channel layer. Therefore, a problem of uneven doping concentration is avoided, and an additional photomask required for a doping process does not need to be added. The process is simple, and application costs are reduced. Further, in the vertical channel transistor, because source/drain metal is in contact with the semiconductor channel, a contact surface is oxidized to some extent in an annealing process, and oxidation increases the contact resistance. After the contact layer is introduced, even if the metal is oxidized, the contact resistance of the transistor device is not greatly affected. Therefore, negative effect of a contact resistance increase due to oxidation of the contact surface between the metal and the channel caused by subsequent annealing can be avoided, and thermal stability of the device can be improved.

Further, when the vertical channel transistor including the interface layer is manufactured, the interface layer can effectively prevent a heavily doped element from diffusing into the insulation dielectric layer, thereby expanding a doping concentration window of the contact layer. The contact layer can be doped at higher concentration, so that a resistance of formed PN junction ohmic contact is smaller. In addition, when the first contact layer and the second contact layer are heavily doped, the heavily doped element can be prevented from diffusing into the insulation isolation layer, and isolation effect of the insulation isolation layer is not affected.

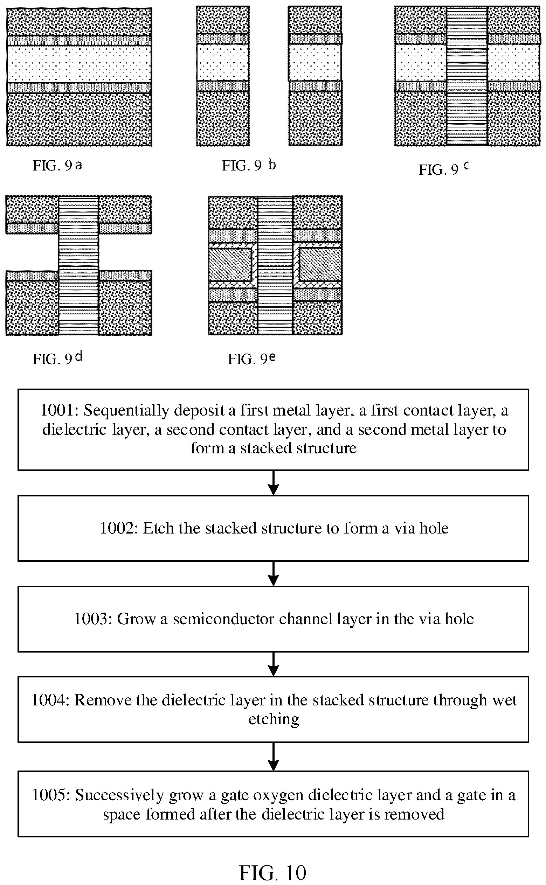

FIG. 9a to FIG. 9e are a schematic flowchart of a manufacturing process of a vertical channel transistor according to an embodiment of this application. FIG. 10 is a schematic flowchart of a corresponding method for manufacturing a vertical channel transistor according to an embodiment of this application. The manufacturing process shown in FIG. 9a to FIG. 9e and FIG. 10 may be used to manufacture the vertical channel transistor shown in FIG. 4a.

The method includes the following steps.

1001: Sequentially deposit a first metal layer, a first contact layer, a dielectric layer, a second contact layer, and a second metal layer to form a stacked structure, as shown in FIG. 9a.

It should be understood that one of the first metal layer and the second metal layer is a source, and the other is a drain. The first contact layer and the second contact layer may be low-resistance semiconductor layers. For optional materials of the five layers, respectively refer to the foregoing descriptions of the materials of the drain 103, the first contact layer 101, the insulation dielectric layer 108, the second contact layer 102, and the source 104. Details are not described herein again.

In an optional solution, a first interface layer may be further grown between the first contact layer and the insulation dielectric layer, and a second interface layer may be grown between the second contact layer and the insulation dielectric layer. For materials of the first interface layer and the second interface layer, refer to the foregoing description of the interface layer 116. Details are not described herein again.

1002: Etch the stacked structure to form a via hole, as shown in FIG. 9b.

It should be understood that the via hole may also be referred to as a groove that penetrates the stacked structure in a vertical direction. Etching is one-step etching.

1003: Grow a semiconductor channel layer in the via hole to form a structure shown in FIG. 9c.

For example, the semiconductor channel layer may be grown by using an ALD process or a CVD process. For the semiconductor channel material, refer to the foregoing description of the semiconductor channel material 106. Details are not described herein again.

1004: Remove the dielectric layer in the stacked structure through wet etching.

As shown in FIG. 9d, after the dielectric layer in the stacked structure is removed, two spaces (or referred to as lateral grooves) are formed, and are located on two sides of the semiconductor channel layer.

1005: Successively grow a gate oxygen dielectric layer and a gate in each space formed after the dielectric layer is removed, to generate a structure shown in FIG. 9e.

In the two grooves, the gate oxygen dielectric layers are first grown through ALD or CVD, and then the gates are respectively grown on the gate oxygen dielectric layers through ALD or the CVD. The groove formed after the dielectric layer is removed has three surfaces: a first side surface facing the first contact layer, an adjacent second side surface facing the second contact layer, and a third surface in contact with the semiconductor channel layer. A gate oxygen dielectric layer is grown on all of the three surfaces. For the gate oxygen dielectric material, refer to the foregoing description of the material of the gate oxygen dielectric layer 107. Details are not described herein again.

It should be understood that a plurality of vertical channel transistor devices are usually manufactured at the same time, and although this is not shown in FIG. 10, the method may further include the following step.

1006: Form isolation between adjacent vertical channel transistors through etching.

In an optional case, when the stacked structure is manufactured in step 1001, the interface layers may be respectively formed between the first contact layer and the dielectric layer, and between the second contact layer and the dielectric layer, that is, the metal layer, the first contact layer, the first interface layer, the dielectric layer, the second interface layer, the second contact layer, and the metal layer are sequentially deposited, to obtain a stacked structure including seven layers, to manufacture the vertical channel transistor including the interface layers. Then, subsequent processing of steps 1002 to 1005 is performed on the stacked structure.

In the manufacturing method in this application, an ohmic contact layer is introduced to reduce a contact resistance between the source/drain and the semiconductor channel layer, and the contact resistance does not need to be reduced by doping the source, the drain, and the semiconductor channel layer. Therefore, a problem of uneven doping concentration is avoided, and an additional photomask required for a doping process does not need to be added. The process is simple, and application costs are reduced. Further, in the vertical channel transistor, because source/drain metal is in contact with the semiconductor channel, a contact surface is oxidized to some extent in an annealing process, and oxidation increases the contact resistance. After the contact layer is introduced, even if the metal is oxidized, a contact resistance of the transistor device is not greatly affected. Therefore, negative effect of a contact resistance increase due to oxidation of the contact surface between the metal and the channel caused by subsequent annealing can be avoided, and thermal stability of the device can be improved.

The foregoing embodiments are merely intended for describing the technical solutions of this application other than limiting this application. Although this application is described in detail with reference to the foregoing embodiments, a person of ordinary skill in the art should understand that modifications may still be made to the technical solutions described in the foregoing embodiments or equivalent replacements may still be made to some technical features thereof, without departing from the scope of the technical solutions of embodiments of this application. For example, for some specific operations in the apparatus embodiments, refer to the foregoing method embodiments.

## Claims

1. A vertical channel transistor structure, comprising:
a stacked structure, wherein the stacked structure comprises a first metal layer, a first contact layer, an insulation dielectric layer, a second contact layer, and a second metal layer, the first contact layer is located between the first metal layer and the insulation dielectric layer, and the second contact layer is located between the second metal layer and the insulation dielectric layer;
the stacked structure is provided with a groove, the groove penetrates the second metal layer, the second contact layer, the insulation dielectric layer, and the second contact layer, and the first groove is at least partially recessed into the first metal layer;
a semiconductor channel layer, a gate oxygen dielectric layer, and a gate are disposed in the groove; and
materials of the first contact layer and the second contact layer are conductor materials or semiconductor materials whose conductivities are higher than that of the semiconductor channel layer, the semiconductor channel layer is separately in contact with the first metal layer and the second metal layer in the groove, and the gate oxygen dielectric layer is disposed between the semiconductor channel layer and the gate.

2. The vertical channel transistor structure according to claim 1, wherein the groove is the first groove, the semiconductor channel layer covers a bottom and a side wall of the first groove to form a second groove, the gate oxygen dielectric layer covers a bottom and a side wall of the second groove to form a third groove, and the gate is disposed in the third groove.

3. The vertical channel transistor structure according to claim 1 or 2, wherein a sum of a resistance of a contact surface formed between the first contact layer and the first metal layer and a resistance of a contact surface formed between the first contact layer and the semiconductor channel layer is less than a resistance of a contact surface formed between the first metal layer and the semiconductor channel layer; and
a sum of a resistance of a contact surface formed between the second contact layer and the second metal layer and a resistance of a contact surface formed between the second contact layer and the semiconductor channel layer is less than a resistance of a contact surface formed between the second metal layer and the semiconductor channel layer.

4. The vertical channel transistor structure according to any one of claims 1 to 3, wherein when the materials of the first contact layer and the second contact layer are the conductor materials,
if the semiconductor channel layer is an N-type semiconductor, the materials of the first contact layer and the second contact layer are first conductor materials, wherein a work function of the first conductor material is less than or close to electron affinity of the semiconductor channel layer; or
if the semiconductor channel layer is a P-type semiconductor, the materials of the first contact layer and the second contact layer are second conductor materials, wherein a work function of the second conductor material is greater than or close to a sum of electron affinity and a band gap of the semiconductor channel layer.

5. The vertical channel transistor structure according to any one of claims 1 to 3, wherein when the materials of the first contact layer and the second contact layer are the semiconductor materials,
if the semiconductor channel layer is a first N-type semiconductor, the materials of the first contact layer and the second contact layer are first semiconductor materials, wherein a conduction band location of the first semiconductor material is close to a conduction band location of the first N-type semiconductor, and a conductivity of the first semiconductor material is greater than or equal to a conductivity of the first N-type semiconductor; or
if the semiconductor channel layer is a first P-type semiconductor, the materials of the first contact layer and the second contact layer are second semiconductor materials, wherein a valence band location of the second conductor material is close to a valence band location of the first P-type semiconductor, and a conductivity of the second conductor material is greater than or equal to a conductivity of the first P-type semiconductor.

6. The vertical channel transistor structure according to any one of claims 1 to 4, wherein the materials of the first contact layer and the second contact layer comprise titanium Ti, gold Au, tungsten W, molybdenum Mo, aluminum Al, or titanium nitride TiN.

7. The vertical channel transistor structure according to any one of claims 1 to 3 or claim 5, wherein the materials of the first contact layer and the second contact layer comprise indium gallium zinc oxide InGaZnO, indium zinc oxide InZnO, indium tin oxide InSnO, indium oxide In2O3, gallium oxide Ga2O3, indium titanium oxide InTiO, or zinc oxide ZnO.

8. The vertical channel transistor structure according to any one of claims 1 to 3 or claim 5, wherein the materials of the first contact layer and the second contact layer comprise heavily doped P-type silicon Si and N-type Si, or any combination of the P-type silicon Si and the N-type Si.

9. The vertical channel transistor structure according to any one of claims 1 to 3, wherein the first contact layer and the second contact layer are doped semiconductor layers, and a material of the doped semiconductor layer is obtained by doping a material of the semiconductor channel layer.

10. The vertical channel transistor structure according to any one of claims 1 to 3, wherein the first contact layer, the second contact layer, and the semiconductor channel layer are all P-type semiconductors or N-type semiconductors;
the first contact layer and the second contact layer are N-type semiconductors, and the semiconductor channel layer is a P-type semiconductor; or
the first contact layer and the second contact layer are P-type semiconductors, and the semiconductor channel layer is an N-type semiconductor.

11. The vertical channel transistor structure according to any one of claims 1 to 10, wherein the vertical channel transistor structure is in a cylindrical shape, the stacked structure surrounds the semiconductor channel layer, and the semiconductor channel layer is completely located in the vertical groove inside the stacked structure.

12. The vertical channel transistor structure according to any one of claims 1 to 10, wherein the vertical channel transistor structure is in a square columnar shape, the stacked structure comprises a first stacked substructure and a second stacked substructure, the semiconductor channel layer comprises a first semiconductor channel layer and a second semiconductor channel layer, and the gate oxygen dielectric layer comprises a first gate oxygen dielectric layer and a second gate oxygen dielectric layer;
the gate is disposed between the first stacked substructure and the second stacked substructure;
the first semiconductor channel layer and the first gate oxygen dielectric layer are disposed between the first stacked substructure and the gate, and the first semiconductor channel layer is in contact with a side surface of the first stacked substructure; and
the second semiconductor channel layer and the second gate oxygen dielectric layer are disposed between the second stacked substructure and the gate, and the second semiconductor channel layer is in contact with a side surface of the second stacked substructure.

13. The vertical channel transistor structure according to any one of claims 1 to 12, further comprising a first interface layer and a second interface layer, wherein the first interface layer is located between the first contact layer and the insulation dielectric layer, and the second interface layer is located between the second contact layer and the insulation dielectric layer.

14. The vertical channel transistor structure according to claim 13, wherein materials of the first interface layer and the second interface layer are the same as the materials of the first contact layer and the second contact layer, but doping concentration of the materials of the first interface layer and the second interface layer is lower than doping concentration of the materials of the first contact layer and the second contact layer.

15. A vertical channel transistor structure, comprising a stacked structure, wherein the stacked structure comprises a first metal layer, a first contact layer, an insulation dielectric layer, a second contact layer, and a second metal layer, the first contact layer is located between the first metal layer and the insulation dielectric layer, and the second contact layer is located between the second metal layer and the insulation dielectric layer;
the stacked structure is provided with a groove, the groove penetrates the second metal layer, the second contact layer, the insulation dielectric layer, and the second contact layer, and the first groove is at least partially recessed into the first metal layer;
a semiconductor channel layer, a gate oxygen dielectric layer, and a gate are disposed in the groove;
the semiconductor channel layer is separately in contact with the first metal layer and the second metal layer in the groove, and the gate oxygen dielectric layer is disposed between the semiconductor channel layer and the gate; and
a resistance of a contact surface formed between the first contact layer and the semiconductor channel layer and a resistance of a contact surface formed between the second contact layer and the semiconductor channel layer are respectively less than a resistance of a contact surface formed between the first metal layer and the semiconductor channel layer and a resistance of a contact surface formed between the second metal layer and the semiconductor channel layer.

16. The vertical channel transistor structure according to claim 15, wherein a resistance of a contact surface formed between the first contact layer and the first metal layer and a resistance of a contact surface formed between the second contact layer and the second metal layer are less than a first threshold.

17. A vertical channel transistor structure, comprising a stacked structure and a semiconductor channel layer, wherein
the stacked structure is provided with a groove, and the semiconductor channel layer is disposed in the groove;
the stacked structure comprises a first metal layer, a second metal layer, and a third metal layer, the third metal layer is located between the first metal layer and the second metal layer, a first interface, a second interface, and a third interface of the third metal layer are wrapped with a first dielectric layer, the first interface is an interface that is of the third metal layer and that faces the first metal layer, the second interface is an interface that is of the third metal layer and that faces the second metal layer, and the third interface is an interface that is of the third metal layer and that faces the semiconductor channel layer;
the stacked structure further comprises a first contact layer and a second contact layer, the first contact layer is located between the first metal layer and the first dielectric layer, and the second contact layer is located between the second metal layer and the first dielectric layer; and
the semiconductor channel layer is separately in contact with the first metal layer and the second metal layer.

18. The vertical channel transistor structure according to claim 17, wherein the groove penetrates the stacked structure.

19. The vertical channel transistor structure according to claim 17 or 18, wherein materials of the first contact layer and the second contact layer are conductor materials, and the conductor materials of the first contact layer and the second contact layer are different from materials of the first metal layer and the second metal layer; or
materials of the first contact layer and the second contact layer are semiconductor materials whose conductivities are higher than that of the semiconductor channel layer.

20. The vertical channel transistor structure according to any one of claims 17 to 19, wherein
a sum of a resistance of a contact surface formed between the first contact layer and the first metal layer and a resistance of a contact surface formed between the first contact layer and the semiconductor channel layer is less than a resistance of a contact surface formed between the first metal layer and the semiconductor channel layer; and
a sum of a resistance of a contact surface formed between the second contact layer and the second metal layer and a resistance of a contact surface formed between the second contact layer and the semiconductor channel layer is less than a resistance of a contact surface formed between the second metal layer and the semiconductor channel layer.

21. The vertical channel transistor structure according to any one of claims 17 to 20, wherein the structure is in a cylindrical shape, the stacked structure surrounds the semiconductor channel layer, and the semiconductor channel layer is completely located in the vertical groove inside the stacked structure.

22. The vertical channel transistor structure according to any one of claims 17 to 20, wherein the structure is in a square columnar shape, the stacked structure comprises a first stacked substructure and a second stacked substructure, the semiconductor channel layer is located between the first stacked substructure and the second stacked substructure, and the first semiconductor channel layer is separately in contact with a side surface of the first stacked substructure and a side surface of the second stacked substructure.

23. The vertical channel transistor structure according to any one of claims 17 to 22, wherein the first contact layer and the second contact layer are doped semiconductor layers, and a material of the doped semiconductor layer is obtained by doping a material of the semiconductor channel layer.

24. The vertical channel transistor structure according to any one of claims 17 to 22, wherein the first contact layer, the second contact layer, and the semiconductor channel layer are all P-type semiconductors or N-type semiconductors;
the first contact layer and the second contact layer are N-type semiconductors, and the semiconductor channel layer is a P-type semiconductor; or
the first contact layer and the second contact layer are P-type semiconductors, and the semiconductor channel layer is an N-type semiconductor.

25. The vertical channel transistor structure according to any one of claims 17 to 24, further comprising a first interface layer and a second interface layer, wherein the first interface layer is located between the first contact layer and the first dielectric layer, and the second interface layer is located between the second contact layer and the first dielectric layer.

26. A method for manufacturing a vertical channel transistor, wherein the method comprises:
sequentially depositing a first metal layer, a first contact layer, an insulation dielectric layer, a second contact layer, and a second metal layer to form a stacked structure;
etching the stacked structure to form a first groove;
growing a semiconductor channel layer in the first groove to form a second groove;
growing a gate oxygen dielectric layer in the second groove to form a third groove; and
growing a gate in the third groove; and
materials of the first contact layer and the second contact layer are conductor materials or semiconductor materials whose conductivities are higher than that of the semiconductor channel layer.

27. The method according to claim 26, wherein after the growing a gate in the third groove, the method further comprises:
etching the gate, the gate oxygen dielectric layer, and the semiconductor channel layer, to form isolation between the vertical channel transistor and another adjacent vertical channel transistor.

28. The method according to claim 26 or 27, wherein
a sum of a resistance of a contact surface formed between the first contact layer and the first metal layer and a resistance of a contact surface formed between the first contact layer and the semiconductor channel layer is less than a resistance of a contact surface formed between the first metal layer and the semiconductor channel layer; and
a sum of a resistance of a contact surface formed between the second contact layer and the second metal layer and a resistance of a contact surface formed between the second contact layer and the semiconductor channel layer is less than a resistance of a contact surface formed between the second metal layer and the semiconductor channel layer.

29. The method according to any one of claims 26 to 28, wherein the materials of the first contact layer and the second contact layer comprise titanium Ti, gold Au, tungsten W, molybdenum Mo, aluminum Al, or titanium nitride TiN.

30. The method according to any one of claims 26 to 28, wherein the materials of the first contact layer and the second contact layer comprise indium gallium zinc oxide InGaZnO, indium zinc oxide InZnO, indium tin oxide InSnO, indium oxide In2O3, gallium oxide Ga2O3, indium titanium oxide InTiO, or zinc oxide ZnO.

31. The method according to any one of claims 26 to 28, wherein the materials of the first contact layer and the second contact layer comprise heavily doped P-type silicon Si and N-type Si, or any combination of the P-type silicon Si and the N-type Si.

32. The method according to any one of claims 26 to 28, wherein the first contact layer and the second contact layer are doped semiconductor layers, and a material of the doped semiconductor layer is obtained by doping a material of the semiconductor channel layer.

33. The method according to any one of claims 26 to 28, wherein when polarities of semiconductors of the first contact layer and the second contact layer are different from a polarity of a semiconductor of the semiconductor channel layer, doping concentration of the first contact layer and the second contact layer is higher than doping concentration of the semiconductor channel layer.

34. The method according to any one of claims 26 to 33, wherein the sequentially depositing a first metal layer, a first contact layer, an insulation dielectric layer, a second contact layer, and a second metal layer to form a stacked structure specifically comprises:
sequentially depositing the first metal layer, the first contact layer, a first interface layer, the insulation dielectric layer, a second interface layer, the second contact layer, and the second metal layer to form the stacked structure.

35. A method for manufacturing a vertical channel transistor, wherein the method comprises:
sequentially depositing a first metal layer, a first contact layer, an insulation dielectric layer, a second contact layer, and a second metal layer to form a stacked structure;
etching the stacked structure to form a via hole;
growing a semiconductor channel layer in the via hole;
removing the insulation dielectric layer from the stacked structure through wet etching; and
successively growing a gate oxygen dielectric layer and a gate in a space formed after the insulation dielectric layer is removed.

36. The method according to claim 35, wherein a sum of a resistance of a contact surface formed between the first contact layer and the first metal layer and a resistance of a contact surface formed between the first contact layer and the semiconductor channel layer is less than a resistance of a contact surface formed between the first metal layer and the semiconductor channel layer; and
a sum of a resistance of a contact surface formed between the second contact layer and the second metal layer and a resistance of a contact surface formed between the second contact layer and the semiconductor channel layer is less than a resistance of a contact surface formed between the second metal layer and the semiconductor channel layer.

37. The method according to claim 35 or 36, wherein materials of the first contact layer and the second contact layer are conductor materials, and the conductor materials of the first contact layer and the second contact layer are different from materials of the first metal layer and the second metal layer; or
materials of the first contact layer and the second contact layer are semiconductor materials whose conductivities are higher than that of the semiconductor channel layer.

38. The method according to any one of claims 35 to 37, wherein the sequentially depositing a first metal layer, a first contact layer, an insulation dielectric layer, a second contact layer, and a second metal layer to form a stacked structure specifically comprises:
sequentially depositing the first metal layer, the first contact layer, a first interface layer, the insulation dielectric layer, a second interface layer, the second contact layer, and the second metal layer to form the stacked structure.
